# EUROPÄISCHE PATENTSCHRIFT

(11) **EP 3 341 135 B1**
(45) Veröffentlichungstag und Bekanntmachung des Hinweises auf die Patenterteilung: **05.06.2019**
(21) Anmeldenummer: 16759714.5
(22) Anmeldetag: 23.08.2016
(51) Int. Cl.: H01L 41/29, H01L 41/047, H01L 41/27, H01L 41/193, H01L 41/297

(54) **VERFAHREN ZUR GENERATIVEN HERSTELLUNG VON DIELEKTRISCHEN ELASTOMER-AKTOREN SOWIE EINEN DRUCKKOPF ZUR DURCHFÜHRUNG DES VERFAHRENS**
METHOD FOR ADDITIVE MANUFACTURING OF DIELECTRIC ELASTOMER ACTUATORS AND A PRINT HEAD FOR PERFORMING THE METHOD
PROCÉDÉ POUR LA FABRICATION GÉNÉRATIVE D'ACTIONNEURS DIÉLECTRIQUES EN ÉLASTOMÈRE ET TÊTE D'IMPRESSION PERMETTANT DE RÉALISER LE PROCÉDÉ

(30) Priorität: 26.08.2015 DE 102015216340
(43) Veröffentlichungstag der Anmeldung: 04.07.2018
(73) Patentinhaber: Fraunhofer-Gesellschaft zur Förderung der angewandten Forschung e.V., 80686 München (DE); Technische Universität Dresden, 01069 Dresden (DE)
(72) Erfinder: KÖCKRITZ, Tilo, 01328 Dresden (DE); PASCHEW, Georgi, 01067 Dresden (DE); POPP, Andreas, 01734 Rabenau (DE); REIMANN, Michael, 01139 Dresden (DE); RICHTER, Andreas, 01219 Dresden (DE)
(74) Vertreter: Pfenning, Meinig & Partner mbB
(86) Internationale Anmeldenummer: PCT/EP2016/069881
(87) Internationale Veröffentlichungsnummer: WO 2017/032769

(56) Entgegenhaltungen:
- EP-A1- 2 826 568
- WO-A1-2014/006005
- WO-A2-2013/034549
- CH-A1- 706 837
- US-B1- 6 543 110
- AARON P GERRATT ET AL: "Dielectric elastomer actuators fabricated using a micro-molding process", SMART MATERIALS AND STRUCTURES, IOP PUBLISHING LTD., BRISTOL, GB, Bd. 23, Nr. 5, 18. März 2014 (2014-03-18), Seite 55004, XP020262305, ISSN: 0964-1726, DOI: 10.1088/0964-1726/23/5/055004 [gefunden am 2014-03-18]

## Beschreibung

Die Erfindung betrifft ein Verfahren zur generativen Herstellung von dielektrischen Elastomer-Aktoren sowie einen Druckkopf zur Durchführung des Verfahrens. Mit dem Verfahren können dielektrische Elastomer-Aktoren bei denen zwischen zwei elastisch verformbaren elektrisch leitenden Schichten eine elastisch verformbare dielektrische Schicht angeordnet ist, hergestellt werden. Es können aber auch dreidimensional gestaltete dielektrische Elastomer-Aktoren bei denen elektrisch leitende elastisch verformbare Bereiche von elastisch verformbaren dielektrischen Bereichen getrennt sind, hergestellt werden. Elastisch verformbare elektrisch leitende Schichten oder Bereiche werden von außen elektrisch kontaktiert. Dazu kann auf bekannte technische Lösungen zurück gegriffen werden.

Die entwickelten vollpolymeren dielektrischen Elastomer-Schichtaufbauten (DEA) bestehen üblicherweise aus mindestens drei polymeren Schichten. Die dielektrische Schicht, die mit dielektrischen Füllstoffen modifiziert sein kann, wird beidseitig von polymeren elektrisch leitfähigen Schichten bedeckt, die mit nanoskaligen elektrisch leitfähigen Füllstoffen modifiziert werden muss. Das Basis-Polymer ist dabei immer das gleiche oder vollkompatibles Material, um eine maximale Kompatibilität zu erreichen. Die notwendigen Eigenschaften werden im Bereich der dielektrischen Schicht bereits durch das unmodifizierte Basis-Polymer erreicht, können aber durch die dielektrischen Füllstoffe weiter verbessert werden. Andererseits muss dieses elektrisch isolierende Basis-Polymer entsprechend modifiziert werden, um eine elektrische Leitfähigkeit für die Elektrodenschicht der elektrisch leitfähigen Schichten zu ermöglichen.

Möglichkeiten dazu sind in DE 10 2008 039 757 A1 beschrieben. Untersuchungen dazu haben ergeben, dass multi-walled Carbon Nanotubes NC7000 als mögliches Beispiel für CNTs, die für die elektrische Modifizierung genutzt wurden, vorgeschlagen. Die Integration von 3,0 Masse-% senkt den spezifischen elektrischen Widerstand von 1,0 x 10¹⁴ Ωm auf 6,3 x 10⁻² Ωm, wodurch allerdings die komplexe Viskosität von 4,2 Pas auf 23070 Pas angehoben wurde. Dieser drastische Anstieg der komplexen Viskosität des die CNTs enthaltenden Basispolymers erschwert die Weiterverarbeitbarkeit sowie die reproduzierbare Herstellung der Schichtverbünde erheblich bzw. verhindert diese sogar.

Diese Problematik wurde für die Herstellungstechnologie von größeren Stückzahlen im Labormaßstab, wie in DE 10 2012 016 375 A1 beschrieben gelöst. Um eine gewisse Variabilität im Herstellungsprozess zu ermöglichen, wurde ein zusätzliches Verfahren entwickelt, um kleine Strukturen bzw. evtentuell entstehende Imhomogenitäten nachzubearbeiten. Hierfür wurde ein auf Laserablation basierender Prozess entwickelt (DE 10 2012 016 376 A1).

Weitere Verfahren und Vorrichtungen nach dem Stand der Technik sind in WO 2013 / 034549 A2; CH 706 837 A1; Aaron P Gerrat et al., "Dielectric elastomer actuators fabricated using a micro-molding process", Smart Materials and Structures, vol. 23, 055004, (2014); WO 2014 / 006005 A1; US 6 543 110 B1 und EP 2 826 568 A1 beschrieben.

Darüber hinaus besteht großes Interesse an der Herstellbarkeit von dielektrischen Elastomeraktoren mit einer hohen geometrischen Vielfalt, mit einem Druckverfahren, mit dem eine dreidimensionale Gestaltung möglich ist. Dabei besteht die Herausforderung darin, das extrem hochviskose elektrisch modifizierte Basis-Polymer druckbar zu machen, ohne dabei die Materialeigenschaften zu beeinflussen.

Es ist daher Aufgabe der Erfindung, Möglichkeiten für eine hochgenaue, reproduzierbare sowie geometrisch variable Herstellung dielektrischer Elastomer-Aktoren anzugeben.

Erfindungsgemäß wird diese Aufgabe mit einem Verfahren, das die Merkmale des Anspruchs 1 aufweist, gelöst. Anspruch 8 betrifft einen Druckkopf mit dem das Verfahren durchgeführt werden kann. Vorteilhafte Ausgestaltungen und Weiterbildungen der Erfindung können mit in untergeordneten Ansprüchen bezeichneten Merkmalen realisiert werden.

Bei dem erfindungsgemäßen Verfahren zur generativen Herstellung von dielektrischen Elastomer-Aktoren werden Schichten eines Basis-Polymers A, in dem elektrisch leitende Bestandteile mit einem Anteil enthalten sind, bei dem die Perkolationsschwelle überschritten ist, einzeln mit einem Druckkopf aufgetragen und dabei ein elektrisch leitender Bereich oder eine solche Schicht ausgebildet. Zwischen Schichten oder Bereichen, die elektrisch leitende Bestandteile enthalten, wird eine dielektrische Schicht oder ein solcher Bereich ausgebildet.

Zumindest Schichten oder Bereiche, die elektrisch leitende Bestandteile enthalten werden dabei mit einem Druckkopf ausgebildet. In den Druckkopf werden ein Basis-Polymer A sowie mindestens ein Additiv C, mit dem eine für ein Drucken ausreichende Reduzierung der Viskosität erreichbar ist und das bei einer Maximaltemperatur von 50 °C in die Gasphase übergeht, in dosierter Form zugeführt und darin vermischt.

Die mit dem Basis-Polymer A und dem mindestens einen Additiv C gebildete Mischung wird durch den Druckkopf zu einer Austrittsdüse gefördert und nach dem Austreten erfolgt eine Verfestigung/Anvernetzung oder Aushärtung des Basis-Polymers A sowie eine Überführung des noch im Basis-Polymer A enthaltenen mindestens einen Additivs C in die Gasphase. So wird eine schichtweise dreidimensionale Ausbildung einer elastisch verformbaren elektrisch leitenden Schicht oder eines solchen Bereiches erreicht.

Vorteilhaft besteht die Möglichkeit, einer Mischung, die mit dem Basis-Polymer A und dem mindestens einen Additiv C gebildet ist, das Additiv C und/oder ein weiteres Additiv D und/oder E, mit dem eine für ein Drucken ausreichende Reduzierung der Viskosität erreichbar ist, in dosierter Form im Druckkopf bei der Förderung in Richtung der Austrittsdüse zusätzlich zuzuführen und weiter vermischten.

Als Additiv C, D und/oder E kann Octamethyltrisiloxan, beispielsweise ein Additiv, das unter der Handelsbezeichnung Corning OS-20 kommerziell erhältlich ist, dem Basis-Polymer A, bevorzugt mit einem Anteil mit maximal 80 Masse-%, bevorzugt maximal 50 Masse-% zugeführt werden. Als Basis-Polymer A kann Polydimethylsiloxan beispielsweise Dow Corning Sylgard 184, das unter dieser Bezeichnung kommerziell erhältlich ist, und in dem 1 Masse-% bis 5 Masse-%, bevorzugt 3 Masse-% Kohlenstoffnanoröhrchen, bevorzugt einwandige Kohlenstoffnanoröhrchen (SWNTs) als elektrisch leitender Bestandteil enthalten sind, eingesetzt werden.

Für den Fall, dass ein Mehrkomponenten Polymer eingesetzt wird, kann der mit dem Basis-Polymer A, in dem elektrisch leitende Bestandteile enthalten sind, sowie dem mindestens eine Additiv C gebildeten Mischung eine Härterkomponente B zugeführt und vermischt werden, bevor die damit gebildete Mischung den Druckkopf verlässt. Die Aushärtung/Anvernetzung des Polymers kann dabei während des Aufenthalts im Druckkopf beginnend und/oder nach dem Austreten durch eine Energiezufuhr, beispielsweise eine Bestrahlung mit elektromagnetischer Strahlung oder Beheizung unterstützt werden.

Das Verdampfen der Additive kann unmittelbar nach dem Austritt aus dem Druckkopf und vor dem Auftreffen auf die Oberfläche auf der die jeweilige Schicht ausgebildet werden soll beginnen, um ein Verlaufen des gedruckten Polymers zu verhindern oder einzelne Tropfen aufstapeln zu können. Additiv(e) kann/können aber auch erst während der Vernetzung verdampfen, um ein gezieltes Verlaufen des noch viskosen Polymers zu erreichen, wodurch dünnere einzelne Schichten ausgebildet werden können.

Bereiche des Druckkopfes, die mit einer Härterkomponente B in Kontakt kommen, sollten mit einem Spülmittel S gereinigt werden können, wenn der Druckkopf außer Betrieb genommen wird, oder ein Wechsel von eingesetztem Basis-Polymer A und/oder Additiv vorgenommen werden soll.

Die Austrittsdüse sollte in einem Abstand zu einer Oberfläche eines Substrates auf dem der dielektrische Elastomer-Aktor aufgebaut wird oder einer obersten bereits ausgebildeten Schicht angeordnet werden, wenn die Mischung die Austrittsdüse verlässt. Dadurch kann ein Anhaften von Polymer an der äußeren Mantelfläche des Druckkopfes vermieden werden.

Vorteilhaft kann es ebenfalls sein, ein Additiv C, D und/oder E vor der Zuführung in das Basis-Polymer A so zu kühlen, dass es in der flüssigen Phase zugeführt wird. Es sollte dazu unterhalb der jeweiligen Siedetemperatur gehalten sein. Dafür kann eine geeignete Kühleinrichtung, beispielsweise ein kühlbarer Vorratsbehälter genutzt werden. Eine weitere Möglichkeit stellt eine Druckerhöhung im Druckkopf dar, um das Verdampfen der Additive auch bei erhöhten Temperaturen zu vermeiden. Die Additive können dann unmittelbar nach dem Austritt aus dem Druckkopf sehr schnell verdampfen.

An einem bei der Erfindung einsetzbaren Druckkopf sind eine Zuführung für ein elektrisch leitende Bestandteile enthaltendes Basis-Polymer A und eine Zuführung für mindestens ein Additiv C sowie mindestens eine Mischkammer vorhanden. Die erhaltene Mischung ist über eine Austrittsdüse (2) aus dem Druckkopf förderbar.

Optional kann am Druckkopf mindestens eine weitere Zuführung für das Additiv C oder mindestens ein weiteres Additiv D und/oder E und/oder eine Zuführung für eine Härterkomponente B und/oder ein Spülmittel S vorhanden sein. Bevorzugt können dabei Härterkomponente B und Spülmittel S mittels eines Ventils wechselweise dem Druckkopf je nach Bedarf zugeführt werden.

Elemente des Druckkopfes, die mit der Härterkomponente B in Kontakt kommen, sollten austauschbar am Druckkopf befestigt sein. Dadurch kann auf eventuell auftretende Betriebsstörungen einfacher und schneller reagiert werden. Im ausgebauten Zustand können diese Elemente auch besser und leichter gereinigt werden.

Die Erfindung verfolgt also den Ansatz, dass über einen mehrstufigen Anpassungsprozess die Materialien in ein druckbares Parameterfeld verschoben werden. Dies bedeutet, dass die komplexe Viskosität deutlich abgesenkt werden sollte und dabei die elektrischen und mechanischen Eigenschaften aber nahezu unbeeinflusst bleiben. Dies kann mit geeigneten Additiven für ein entsprechendes Basis-Polymer A erreicht werden.

So kann beispielsweise ein zweikomponentiges Silikon (DowCorning Sylgard 184) als Basis-Polymer A mit einem Additiv C Dow Corning OS-20 vermischt werden, so dass die Viskosität temporär reduziert werden kann, um ein Drucken der Mischung zu ermöglichen. Ein bei der Erfindung einsetzbares Additiv sollte bei möglichst kleiner Temperatur, bevorzugt bei normaler Umgebungstemperatur (20 °C - 25 °C) verdampfen, um nach der Verfestigung/Aushärtung des Basis-Polymers die Polymereigenschaften nicht zu beeinflussen. Das Verdampfen sollte möglichst rückstandsfrei erfolgen und die optischen Eigenschaften des Basis-Polymers sollten nicht beeinflusst werden, sprich das Additiv sollte farblos und klar sein. Diese Eigenschaften erfüllt ein Spezialadditiv (Lösungsmittel) für Silikone, das ein Octamethyltrisiloxan ist und beispielsweise unter der Handelsbezeichnung DowCorning OS-20 kommerziell erhältlich ist. Die Absenkung der komplexen Viskosität wurde für dieses unmodifizierte und elektrisch leitende Basis-Polymer untersucht. Im Bereich des unmodifizierten Silikons konnte die komplexe Viskosität von 4,2 Pas auf 0,2 Pas abgesenkt werden, dementsprechend liegt die Viskosität unterhalb der von Wasser. Dies wurde mit einem Additivanteil von 50 Masse-% im Basis-Polymer erreicht, wodurch die elektrischen Eigenschaften unbeeinflusst blieben und sich die mechanischen Eigenschaften nur marginal geändert haben. Einen positiven Nebeneffekt stellt die gleichzeitig erreichbare Schichtminimierung dar, da das nach dem Austritt aus der Austrittsdüse in die Gasphase überführte Additiv für einen Volumenverlust sorgt. Mit dem Einsatz von 50 Masse-% des Additivs kann eine Schichtdickenreduktion von 50 % einer einzelnen gedruckten Schicht erreicht werden. Dies ist besonders bei der gewünschten Miniaturisierung und Ausbildung filigraner Geometrien eines dielektrischen Elastomer-Aktors ein wichtiger Vorteil. Der Verdampfungsprozess kann bereits bei normaler Umgebungstemperatur erfolgen. Er kann aber mit einer Warmaushärtung deutlich beschleunigt werden, so dass das/die Additiv(e) in sehr kleiner Zeit aus der jeweiligen gedruckten einzelnen Polymerschicht abdampfen kann/können. Es verbleibt eine Restkonzentration des/der dem Basis-Polymer zugesetzten jeweiligen Additive(s) unterhalb von 1 ppm. Im Bereich einer elektrisch leitfähigen Polymerschicht kann durch die Zugabe des/der Additive(s) eine Reduktion der komplexen Viskosität von 23070 Pas auf 1582 Pas erreicht werden, wodurch ein Druckprozess ermöglicht wird. Die elektrischen Eigenschaften werden nicht und die mechanischen Eigenschaften werden im Vergleich zum additivfreien reinen Basis-Polymer nur marginal verändert. Die Schichtdickenreduktion kann bei einer elektrisch nicht leitfähigen Polymerschicht ebenso ausgenutzt werden. Diese liegt aber lediglich bei ca. 30 %.

Der Druck der dielektrischen Elastomer-Schichtaufbauten sollte auf einer berührungslosen Beschichtung eines vorvernetzten Dielektrikums als Basis-Polymer, das dem Prozess automatisch zugeführt, positioniert und an die vorhergehende Schicht angepresst wird, basieren. Alternativ können ebenso großflächige Bereiche bedruckt werden, die anschließend zusammengeführt werden und somit der Schichtaufbau erhalten wird. Dabei könnten die Schichten z.B. aufeinander gerollt oder gefaltet werden. Die zugeführten Materialien können ebenso eine Makro-/ Mikro-/ Nanostruktur enthalten. Hintergrund der Strukturierung könnte eine gezielte Deformation eines dielektrischen Elastomer-Aktors sein,

Zur Herstellung eines dielektrischen Elastomer-Aktors kann ein Druckkopf eingesetzt werden, der die automatisierte Verarbeitung mit den benannten Eigenschaften ermöglicht. Zu Beginn wird das modifizierte Basis-Polymer mit einem Additiv vermischt und dabei das Additiv homogen im Basis-Polymer verteilt, um die Viskosität des Basis-Polymers möglichst gleichmäßig herabzusetzen. Am Druckkopf kann eine weitere Zuführung für ein Additiv vorhanden sein, durch die entweder das gleiche Additiv oder mindestens ein weiteres Additiv zugegeben werden kann und in einem nachfolgend angeordneten Mischkammerbereich eine Vermischung erfolgt. Die Zugabe des/der Additive(s) in mehreren Schritten kann sinnvoll sein, da dadurch eine eventuelle Klumpenbildung oder Agglomeration verhindert werden kann und sehr homogene Mischungen hergestellt werden können. Die Zugabe eines weiteren Additivs kann notwendig sein, wenn dem Basis-Polymer weitere spezielle Eigenschaften hinzugefügt werden sollen. Nachdem das/die Additiv(e) homogen im Basis-Polymer vermischt wurde(n), kann in die Mischung eine Härterkomponente B für das Basis-Polymer über eine weitere Zuführung zugeführt werden. In der weiteren Zuführung kann ein Ventil in einer Bypassleitung vorhanden sein, um vor dem Abschalten der Anlage oder einem Wechsel des eingesetzten Basis-Polymers A die Härterkomponente B aus dem Druckkopf mit einem Spülmittel S zu spülen, um ein ungewolltes Vernetzen zu verhindern. Die Bereiche der Mischung, die in Bewegungsrichtung der mit Additiv und Basis-Polymer gebildeten Mischung vor der Zuführung der Härterkomponente B angeordnet sind, können dauerhaft im System verbleiben, da in diesem Bereich keine Gefahr der Vernetzung besteht. Bereiche oder Elemente des Druckkopfes, die in Bewegungsrichtung der Mischung nach der Zuführung für die Härterkomponente B angeordnet sind, sollten austauschbar als Wechselsystem ausgebildet sein. Alternativ können diese Bereiche auch durch gründliches Spülen mit Spülmittel S von der Härterkomponente B befreit werden.

Eine dielektrische Schicht kann ebenso über einen separaten Druckkopf mit gleichem Aufbau ausgebildet werden oder als vorvernetzte Folie von der Rolle oder als ebene Folie automatisiert zugeführt werden. Eine Anvernetzung oder Endvernetzung kann mittels mindestens einer integrierten Strahlungsquelle erfolgen (IR, UV, ...). Der Druckkopf sollte mindestens eine Bewegung mit drei Freiheitsgraden ermöglichen, die Aufrüstung mit weiteren Achsen, insbesondere Drehachsen ist vorteilhaft, wenn komplexe geometrische Gestaltungen ausgebildet werden sollen. Der Druckkopf kann auch mit mehreren Austrittsdüsen ausgestattet sein, um die Flächenrate des Prozesses zu steigern. Mindestens eine Austrittsdüse kann auch als Schlitzdüse ausgebildet sein.

Am Druckkopf kann mindestens eine Gasaustrittsdüse zur Ausbildung eines Luftvorhangs zwischen Austrittsdüse und der Oberfläche eines Substrates auf dem ein dielektrischer Elastomer-Aktor generativ ausgebildet wird, vorhanden sein. Mit einem damit ausgebildeten Luftvorhang kann das Verdampfen von Additiv(en) bis zum Auftreffen auf der Oberfläche beeinflusst werden. Es kann eine möglichst niedrige Viskosität auf der Oberfläche zur Ausbildung einzelner dünner Schichten eingehalten werden. Mit einem entsprechend ausgebildeten Luftvorhang kann auch eine Beeinflussung der Form des aus der/den Austrittsdüsen austretenden Polymerstroms erreicht werden. Man kann dies auch als "Airblade" bezeichnen. Neben Luft kann auch ein Schutzgas für die Ausbildung eines Luftvorhangs eingesetzt werden.

Mit einem Luftvorhang können auch Verschmutzungen der Oberfläche eines Substrats, auf der ein dielektrischer Elastomer-Aktor generativ aufgebaut wird, und/oder bereits ausgebildeter Schichten vermieden oder beseitigt werden.

An einem Druckkopf kann vorteilhaft auch ein Ventil für einen Gasaustausch mit der Umgebung vorhanden sein, über das ein Entweichen von Luft sowie ggf. bereits in die Gasphase übergegangene(s) Additiv(e) aus dem Druckkopf in die Umgebung möglich ist. Mindestens ein solches Ventil kann im Bereich einer Mischkammer angeordnet sein.

Das Verfahren kann aber auch unter Vakuumbedingungen durchgeführt werden.

Es kann eine große Geometrievielfalt von dielektrischen Elastomer-Aktoren flexibel mit der Erfindung hergestellt werden.

Nachfolgend soll die Erfindung beispielhaft näher erläutert werden.

Dabei zeigt:

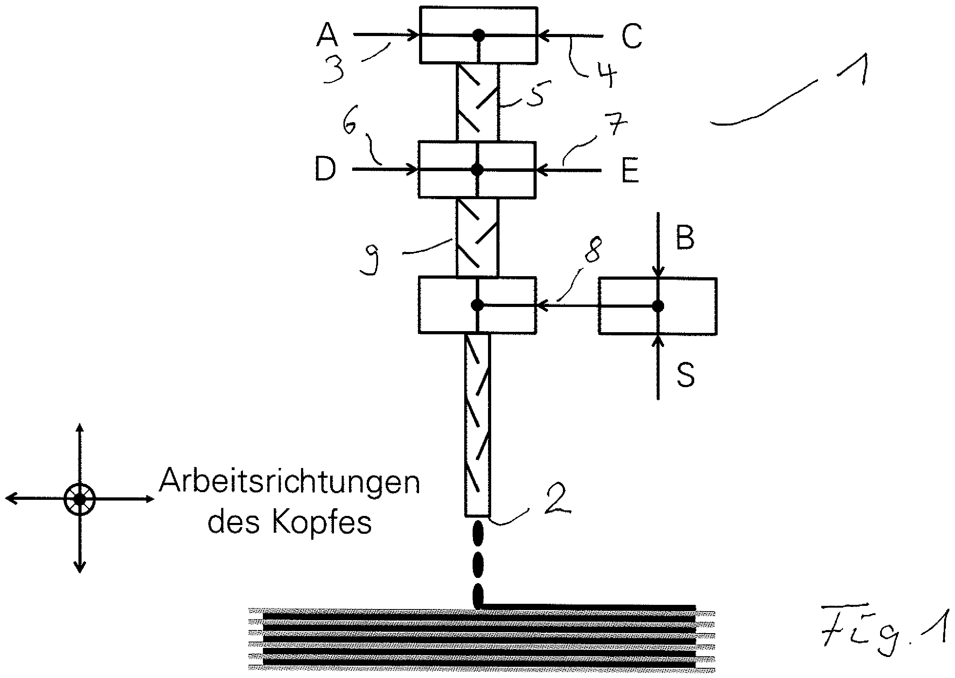

- Figur 1: in schematischer Darstellung einen Druckkopf, mit dem dielektrische Elastomer-Aktoren herstellbar sind.

Dem Druckkopf 1 wird über eine Zuführung 3 ein unter erhöhten Druck stehendes additionsvernetzendes Silikon als Basis-Polymer A in dem 3 Masse-% an Kohlenstoffnanoröhrchen (z.B. Nanocyl NC7000) als elektrisch leitender Bestandteil enthalten sind mit einer Ausgangsviskosität von 23070 Pas und über eine weitere Zuführung 4 ein erstes Additiv C in dosierter und flüssiger Form zugegeben. Die so erhaltene Mischung enthielt das Additiv C mit einem Anteil von 50 Masse-%. Die Mischung wurde in der ersten Mischkammer 5 intensiv vermischt, so dass eine homogene Verteilung der drei Komponenten in der Mischung erreicht worden ist.

In Förderrichtung nachfolgend an die erste Mischkammer 5 sind am Drucckopf 1 zwei weitere Zuführungen 6 und 7 für die Zufuhr flüssiger Additive D und E vorhanden. Dabei kann es sich beispielsweise bei dem Additiv D um ein Dispergierhilfsmittel und beim Additiv E um ein Alterungsschutzmittel handeln. Diese weiteren Additive könnten bei Bedarf beigemengt und in der zweiten Mischkammer 9 weiter vermischt werden, um die benötigten Eigenschaften des herzustellenden dielektrischen Elastomer-Aktors zu optimieren. Die Zugabe des Additivs C bewirkte die Absenkung der Viskosität auf 1582 Pas.

Nachfolgend an die zweite Mischkammer 9 ist eine weitere Zuführung 8 vorhanden, über die der Mischung wechselweise die Härterkomponente B oder ein Spülmittel S zugeführt werden kann. Als Härterkomponente B wurde die Komponente des Herstellergebindes mit einem Verhältnis von 10:1 (Komponente A ohne Füllstoff: Komponente B) zugeführt. Als Spülmittel S kann ebenso DowCorning OS-20 zugeführt werden.

Der Druckkopf 1 wurde zweidimensional bewegt und es konnten elektrisch leitende elastisch verformbare Schichten zwischen denen elastisch verformbare dielektrische Schichten übereinander ausgebildet werden. Der so hergestellte dielektrische Elastomer-Aktor hatte also einen Mehrschichtaufbau. An die elektrisch leitenden elastisch verformbaren Schichten konnte elektrische Spannung über nach dem Stand der Technik ausgebildete elektrische Kontaktanschlüsse angelegt werden.

Der Druckkopf 1 wurde auch senkrecht zur Oberfläche der ausgebildeten Schichten nachgeführt, so dass ein konstanter Abstand zwischen der Austrittsdüse 2 und der jeweiligen Oberfläche des Mehrschichtaufbaus eingehalten werden konnte.

In nicht dargestellter Form können einzelne Schichten auch unterschiedliche Größen oder Randgeometrien aufweisen, so dass ein komplexer dreidimensional gestalteter dielektrischer Elastomer-Aktor hergestellt werden kann, der an eine bestimmte Applikation angepasst ist.

## Patentansprüche

1. Verfahren zur generativen Herstellung von dielektrischen Elastomer-Aktoren, bei dem
Schichten eines Basis-Polymers A, in dem elektrisch leitende Bestandteile mit einem Anteil enthalten sind, bei dem die Perkolationsschwelle überschritten ist, einzeln mit einem Druckkopf (1) aufgetragen und dabei ein elektrisch leitender Bereich oder eine solche Schicht ausgebildet wird,
zwischen Schichten oder Bereichen, die elektrisch leitende Bestandteile enthalten, wird eine dielektrische Schicht oder ein solcher Bereich ausgebildet;
**dadurch gekennzeichnet, dass**
zumindest Schichten oder Bereiche, die elektrisch leitende Bestandteile enthalten mit einem Druckkopf (1) ausgebildet werden, und in den Druckkopf ein Basis-Polymer A sowie mindestens ein Additiv C, mit dem eine für ein Drucken ausreichende Reduzierung der Viskosität erreichbar ist und das bei einer Maximaltemperatur von 80 °C in die Gasphase übergeht, in dosierter Form zugeführt und darin vermischt werden, und
die mit dem Basis-Polymer A und dem mindestens einen Additiv C gebildete Mischung durch den Druckkopf (1) zu einer Austrittsdüse (2) gefördert, und
nach dem Austreten eine Verfestigung/Anvernetzung oder Aushärtung des Basis-Polymers A sowie eine Überführung des noch im Basis-Polymer A enthaltenen mindestens einen Additivs C in die Gasphase erreicht werden und
so eine schichtweise dreidimensionale Ausbildung einer elastisch verformbaren elektrisch leitenden Schicht oder eines solchen Bereiches erreicht wird.

2. Verfahren nach Anspruch 1, **dadurch gekennzeichnet, dass** einer Mischung, die mit dem Basis-Polymer A und dem mindestens einen Additiv C gebildet ist, das Additiv C und/oder ein weiteres Additiv D und/oder E, mit dem eine für ein Drucken ausreichende Reduzierung der Viskosität erreichbar ist, in dosierter Form im Druckkopf (1) bei der Förderung in Richtung der Austrittsdüse (2) zusätzlich zugeführt und weiter vermischt wird.

3. Verfahren nach Anspruch 1 oder 2, **dadurch gekennzeichnet, dass** als Additiv C, D und/oder E Octamethyltrisiloxan dem Basis-Polymer A, bevorzugt mit einem Anteil im Bereich bis maximal 80 Masse-%, bevorzugt bis maximal 50 Masse-% zugeführt wird/werden und/oder
als Basis-Polymer A Polydimethylsiloxan in dem 1 Masse-% bis 5 Masse-%, bevorzugt 3 Masse.% an Kohlenstoffnanoröhrchen als elektrisch leitender Bestandteil enthalten sind, eingesetzt wird.

4. Verfahren nach einem der vorhergehenden Ansprüche, **dadurch gekennzeichnet, dass** der mit dem Basis-Polymer A, in dem elektrisch leitende Bestandteile enthalten sind, sowie das mindestens eine Additiv C gebildeten Mischung eine Härterkomponente B zugeführt und vermischt wird, bevor die damit gebildete Mischung den Druckkopf (1) verlässt.

5. Verfahren nach einem der vorhergehenden Ansprüche, **dadurch gekennzeichnet, dass** die Austrittsdüse (2) in einem Abstand zu einer Oberfläche eines Substrates auf dem der dielektrische Elastomer-Aktor aufgebaut wird oder einer obersten bereits ausgebildeten Schicht angeordnet wird, wenn die Mischung die Austrittsdüse (2) verlässt.

6. Verfahren nach einem der vorhergehenden Ansprüche, **dadurch gekennzeichnet, dass** Bereiche des Druckkopfes (1), die mit einer Härterkomponente B in Kontakt kommen, mit einem Spülmittel S gereinigt werden.

7. Verfahren nach einem der vorhergehenden Ansprüche, **dadurch gekennzeichnet, dass** ein Additiv C, D und/oder E vor der Zuführung in das Basis-Polymer A gekühlt und dadurch in der flüssigen Phase zugeführt wird und/oder
im Druckkopf (1) und/oder nach dem Austreten der Mischung aus der Austrittsdüse (2) eine Energiezufuhr für ein Aushärten/Anvernetzen des Polymers durchgeführt wird.

8. Verfahren nach einem der vorhergehenden Ansprüche, **dadurch gekennzeichnet, dass** eine oder mehrere dielektrische Schicht(en) über einen separaten Druckkopf ausgebildet oder als vorvernetzte Folie von der Rolle oder als ebene Folie zugeführt wird/werden.

9. Druckkopf zur Durchführung des Verfahrens nach einem der vorhergehenden Ansprüche, **dadurch gekennzeichnet, dass** am Druckkopf (1) eine Zuführung (3) für ein elektrisch leitende Bestandteile enthaltendes Basis-Polymer A und eine Zuführung (4) für mindestens ein Additiv C sowie mindestens eine Mischkammer (5) vorhanden sind und die erhaltene Mischung über eine Austrittsdüse (2) aus dem Druckkopf (1) förderbar ist.

10. Druckkopf nach dem vorhergehenden Anspruch, **dadurch gekennzeichnet, dass** am Druckkopf (1) mindestens eine weitere Zuführung (6, 7) für das Additiv C oder mindestens ein weiteres Additiv D und/oder E und/oder
eine Zuführung (8) für eine Härterkomponente B und/oder ein Spülmittel S vorhanden sind, wobei bevorzugt Härterkomponente B und Spülmittel S mittels eines Ventils wechselweise dem Druckkopf (1) zuführbar sind.

11. Druckkopf nach den beiden vorhergehenden Ansprüchen, **dadurch gekennzeichnet, dass** Elemente des Druckkopfes (1), die mit der Härterkomponente B in Kontakt kommen, austauschbar am Druckkopf (1) befestigt sind.

12. Druckkopf nach den drei vorhergehenden Ansprüchen, **dadurch gekennzeichnet, dass** mindestens das eine Additiv C und/oder mindestens ein weiteres Additiv D oder E in einer Kühleinrichtung, die vor einer Zuführung (4, 6, 7) angeordnet ist, auf eine Temperatur unterhalb der Siedetemperatur des/der Additive(s) C, D und/oder E gehalten ist/sind
und/oder
mindestens eine Gasaustrittsdüse zur Ausbildung eines Luftvorhangs zwischen Austrittsdüse (2) und der Oberfläche eines Substrates auf dem ein dielektrischer Elastomer-Aktor generativ ausgebildet wird, vorhanden ist.

13. Druckkopf nach einem der vorhergehenden Ansprüche, **dadurch gekennzeichnet, dass** die Austrittsdüse (2) als Schlitzdüse ausgebildet ist
und/oder
mehrere Austrittsdüsen am Druckkopf (1) vorhanden sind
und/oder
am Druckkopf (1) mindestens ein Ventil für einen Gasaustausch zur Umgebung vorhanden ist.

## Claims

1. Method of additive manufacturing of dielectric elastomer actuators, in which
layers of a base polymer A including electrically conductive constituents with a proportion at which the percolation threshold is exceeded are applied individually with a print head (1), forming an electrically conductive region or such a layer,
a dielectric layer or such a region is formed between layers or regions containing electrically conductive constituents;
**characterized in that**
at least layers or regions containing electrically conductive constituents are formed with a print head (1), and a base polymer A and at least one additive C with which a reduction in viscosity sufficient for printing is achievable and which is converted to the gas phase at a maximum temperature of 80°C are fed in dosed form into the print head and mixed therein, and
the mixture formed by the base polymer A and the at least one additive C is conveyed through the print head (1) to an exit nozzle (2), and,
after the exit, solidification/partial crosslinking or curing of the base polymer A and conversion of the at least one additive C still present in the base polymer A to the gas phase are achieved and
layer-by-layer three-dimensional formation of an elastically deformable electrically conductive layer or such a region is thus achieved.

2. Method according to Claim 1, **characterized in that** the additive C and/or a further additive D and E with which a reduction in viscosity sufficient for printing is achievable is additionally supplied to and subjected to further mixing with a mixture formed by the base polymer A and the at least one additive C in dosed form in the print head (1) in the course of conveying in the direction of the exit nozzle (2).

3. Method according to Claim 1 or 2, **characterized in that** the additive C, D and E supplied to the base polymer A is octamethyltrisiloxane, preferably with a proportion in the range up to a maximum of 80% by mass, preferably up to a maximum of 50% by mass, and/or
the base polymer A used is polydimethylsiloxane including 1% by mass to 5% by mass, preferably 3% by mass, of carbon nanotubes as electrically conductive constituent.

4. Method according to any of the preceding claims, **characterized in that** a hardener component B is supplied to and mixed with the mixture formed by the base polymer A including electrically conductive constituents and the at least one additive C, before the mixture thus formed leaves the print head (1).

5. Method according to any of the preceding claims, **characterized in that** the exit zozzle (2) is arranged at a distance from a surface of a substrate on which the dielectric elastomer actuator is formed or an uppermost layer that has already been formed when the mixture leaves the exit nozzle (2).

6. Method according to any of the preceding claims, **characterized in that** regions of the print head (1) that come into contact with a hardener component B are cleaned with a rinsing agent S.

7. Method according to any of the preceding claims, **characterized in that** an additive C, D and E is cooled before being supplied to the base polymer A and hence supplied in the liquid phase and/or
an energy input for curing/partial crosslinking of the polymer is conducted in the print head (1) and/or after the exit of the mixture from the exit nozzle (2).

8. Method according to any of the preceding claims, **characterized in that** one or more dielectric layer(s) is/are formed by means of a separate print head or supplied as a precrosslinked film from the roll or as a two-dimensional film.

9. Print head for conducting the method according to any of the preceding claims, **characterized in that** there are a feed (3) for a base polymer A containing electrically conductive constituents and a feed (4) for at least one additive C and also at least one mixing chamber (5) in the print head (1) and the mixture obtained is conveyable out of the print head (1) via an exit nozzle (2).

10. Print head according to the preceding claim, **characterized in that** there are at least one further feed (6, 7) for the additive C or at least one further additive D and E and/or
a feed (8) for a hardener component B and/or a rinsing agent S in the print head (1), where hardener component B and rinsing agent S are preferably suppliable alternately to the print head (1) by means of a valve.

11. Print head according to either of the two preceding claims, **characterized in that** elements of the print head (1) that come into contact with the hardener component B are secured exchangably to the print head (1).

12. Print head according to any of the three preceding claims, **characterized in that** at least the one additive C and/or at least one further additive D or E is kept at a temperature below the boiling temperature of the additive(s) C, D and E in a cooling device arranged upstream of a feed (4, 6, 7)
and/or
there is at least one gas exit nozzle for forming an air curtain between exit nozzle (2) and the surface of a substrate on which a dielectric elastomer actuator is formed by additive manufacturing.

13. Print head according to any of the preceding claims, **characterized in that** the exit nozzle (2) takes the form of a slot die
and/or
there are multiple exit nozzles in the print head (1)
and/or
there is at least one valve for exchange of gas with the environment in the print head (1).

## Revendications

1. Procédé de fabrication générative d'actionneurs élastomères diélectriques, dans lequel
des couches d'un polymère de base A qui contient des constituants conducteurs de l'électricité selon une proportion pour laquelle il y a dépassement du seuil de percolation, sont appliquées à titre individuel à l'aide d'une tête d'impression (1), ce qui réalise une zone conductrice de l'électricité ou une couche de ce type,
une couche diélectrique ou une zone de ce type est réalisée entre les couches ou les zones qui contiennent des constituants conducteurs de l'électricité ;
**caractérisé en ce que**
au moins des couches ou des zones qui contiennent des constituants conducteurs de l'électricité sont réalisées à l'aide d'une tête d'impression (1), et un polymère de base A, ainsi qu'au moins un additif C, à l'aide duquel il est possible d'atteindre une réduction de la viscosité suffisante pour l'impression, et qui passe en phase gazeuse à une température maximale de 80 °C, sont amenés dans la tête d'impression sous forme dosée et y sont mélangés, et
le mélange formé avec le polymère de base A et l'au moins un additif C est, en passant par la tête d'impression (1), transporté jusqu'à une buse de sortie (2), et
après cette sortie, on atteint une solidification/un début de réticulation ou un durcissement du polymère de base A, ainsi qu'un passage en phase gazeuse de l'au moins un additif C encore contenu dans le polymère de base A, et
on atteint ainsi une réalisation tridimensionnelle par couches d'une couche conductrice de l'électricité pouvant subir une déformation élastique ou d'une zone de ce type.

2. Procédé selon la revendication 1, **caractérisé en ce qu'**un mélange, qui est formé avec le polymère de base A et l'au moins un additif C, l'additif C et/ou un additif supplémentaire D et/ou E, à l'aide duquel il est possible d'atteindre une réduction de la viscosité suffisante pour l'impression, sont en outre amenés sous forme dosée dans la tête d'impression (1) lors du transport dans la direction de la buse de sortie (2), et subissent un mélange supplémentaire.

3. Procédé selon la revendication 1 ou 2, **caractérisé en ce qu'**on ajoute, en tant qu'additif C, D et/ou E, de l'octaméthyltrisiloxane au polymère de base A, de préférence selon une proportion allant jusqu'à un maximum de 80 % en masse, de préférence jusqu'à un maximum de 50 % en masse et/ou
on utilise, en tant que polymère de base A, un polydiméthylsiloxane qui contient, en tant que constituant conducteur de l'électricité, 1 % en masse à 5 % en masse, de préférence 3 % en masse de nanotubes de carbone.

4. Procédé selon l'une des revendications précédentes, **caractérisé en ce qu'**un composant durcisseur B est ajouté et mélangé au mélange formé avec le polymère de base A, qui contient des constituants conducteur de l'électricité, ainsi que l'au moins un additif C, avant que le mélange ainsi formé ne quitte la tête d'impression (1).

5. Procédé selon l'une des revendications précédentes, **caractérisé en ce que** la buse (2) est disposée à une certaine distance d'une surface d'un substrat sur lequel est réalisé l'actionneur élastomère diélectrique, ou sur la couche la plus supérieure déjà réalisée, lorsque le mélange quitte la buse de sortie (2).

6. Procédé selon l'une des revendications précédentes, **caractérisé en ce que** les zones de la tête d'impression (1) qui entrent en contact avec un composant durcisseur B sont nettoyées avec un agent de rinçage S.

7. Procédé selon l'une des revendications précédentes, **caractérisé en ce qu'**un additif C, D et/ou E est, avant son ajout au polymère de base A, refroidi, et de ce fait ajouté en phase liquide, et/ou
dans la tête d'impression (1), ou après que le mélange a quitté la buse de sortie (2), on procède à un apport d'énergie pour un durcissement/un début de réticulation du polymère.

8. Procédé selon l'une des revendications précédentes, **caractérisé en ce qu'**une ou plusieurs couches diélectriques sont réalisées à l'aide d'une tête d'impression distincte, et/ou sont amenées en tant que feuille pré-réticulée à partir du rouleau, ou sous forme d'une feuille plane.

9. Tête d'impression pour l'exécution du procédé selon l'une des revendications précédentes, **caractérisée en ce qu'**au niveau de la tête d'impression (1) se trouvent une amenée (3) pour un polymère de base A contenant des constituants conducteurs de l'électricité et une amenée (4) pour au moins un additif C, ainsi qu'au moins une chambre de mélange (5), le mélange obtenu pouvant être expulsé de la tête d'impression (1) en passant par une buse de sortie (2).

10. Tête d'impression selon la revendication précédente, **caractérisée en ce qu'**au niveau de la tête d'impression (1) sont présentes au moins une amenée supplémentaire (6, 7) pour l'additif C ou au moins un additif supplémentaire D et/ou E et/ou
une amenée (8) pour un composant durcisseur B et/ou un agent de rinçage S, le composant durcisseur B et l'agent de rinçage S pouvant de préférence être amenés à la tête d'impression (1) en alternance à l'aide d'une vanne.

11. Tête d'impression selon les deux revendications précédentes, **caractérisée en ce que** les éléments de la tête d'impression qui entrent en contact avec le composant durcisseur B sont fixés à la tête d'impression (1) d'une manière amovible.

12. Tête d'impression selon les trois revendications précédentes, **caractérisée en ce que** l'au moins un additif C et/ou l'au moins un additif supplémentaire D ou E sont, dans un dispositif de refroidissement disposé dans une amenée (4, 6, 7), maintenus à une température inférieure à la température d'ébullition du ou des additifs C, D et/ou E,
et/ou
au moins une buse de sortie des gaz est présente pour réaliser un rideau d'air entre la buse de sortie et la surface d'un substrat sur lequel un actionneur élastomère diélectrique est réalisé par fabrication générative.

13. Tête d'impression selon l'une des revendications précédentes, **caractérisée en ce que** la buse de sortie (2) est conçue comme une buse à fente,
et/ou
plusieurs buses de sortie sont présentes sur la tête d'impression (1),
et/ou
au moins une vanne destinée à un échange de gaz avec l'environnement est présente sur la tête d'impression (1).
